(19) Europäisches Patentamt
European Patent Office
Office européen des brevets

(11) EP 3 533 602 A1

(12) EUROPEAN PATENT APPLICATION
published in accordance with Art. 153(4) EPC

(43) Date of publication:
**04.09.2019 Bulletin 2019/36**

(21) Application number: **17864033.0**

(22) Date of filing: **20.10.2017**

(51) Int Cl.:
***B32B 7/02*** *(2019.01)* ***C23C 14/06*** *(2006.01)*
***C23C 16/42*** *(2006.01)* ***H01L 51/50*** *(2006.01)*
***H05B 33/04*** *(2006.01)* ***H05B 33/28*** *(2006.01)*
***B32B 9/00*** *(2006.01)* ***B32B 27/00*** *(2006.01)*

(86) International application number:
**PCT/JP2017/037972**

(87) International publication number:
**WO 2018/079429 (03.05.2018 Gazette 2018/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **28.10.2016 JP 2016211517**

(71) Applicant: **Lintec Corporation**
**Tokyo 173-0001 (JP)**

(72) Inventors:
- **NAGANAWA Satoshi**
  **Tokyo 173-0001 (JP)**
- **OHASHI Takehiro**
  **Tokyo 173-0001 (JP)**
- **IWAYA Wataru**
  **Tokyo 173-0001 (JP)**

(74) Representative: **Adam, Holger et al**
**Kraus & Weisert**
**Patentanwälte PartGmbB**
**Thomas-Wimmer-Ring 15**
**80539 München (DE)**

(54) **LAMINATE FILM, ELECTRONIC DEVICE MEMBER, AND ELECTRONIC DEVICE**

(57) The present invention provides a laminate film comprising at least a base and a gas barrier layer, elongation strain (ε) generated in a surface of the gas barrier layer, which is calculated by a following formula (1), is 0.8% or less; an electronic device member including the laminate film; and an electronic device equipped with the electronic device member. In formula (1), T is a distance [m] from a surface farthest from the gas barrier layer to the gas barrier layer in a thickness direction of the laminate film, and λ is a distance, from the surface of the laminate film, of a hypothetical plane (α) in the laminate film in which stress does not occur. According to the present invention, there are provided a laminate film excellent in gas barrier properties and bending properties, an electronic device member including this laminate film, and an electronic device equipped with this electronic device member.

$$\varepsilon = (T - \lambda) / \{(3 \times 10^{-3}) + \lambda\} \times 100 \quad (1)$$

EP 3 533 602 A1

Fig.2

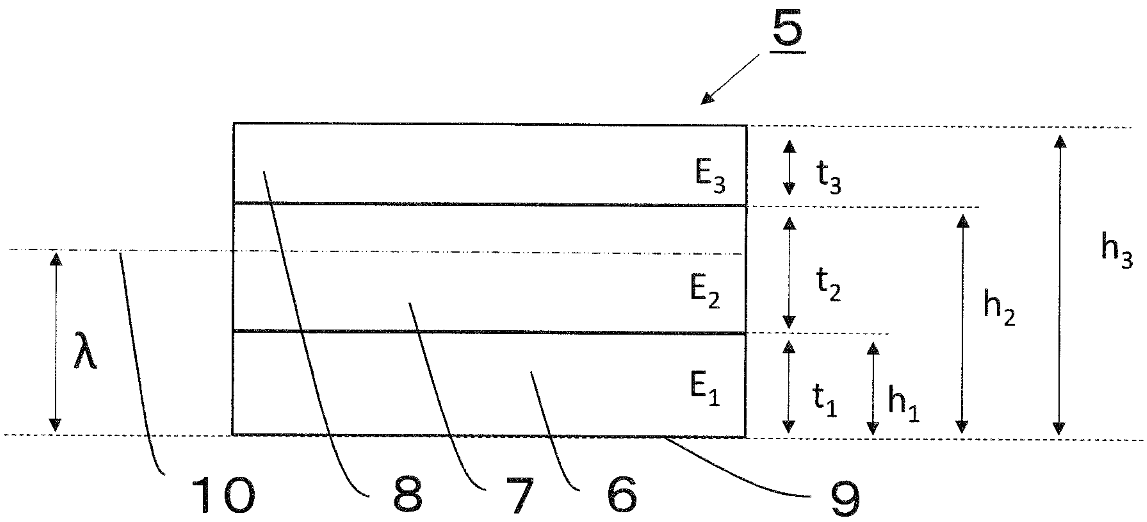

## Description

### TECHNICAL FIELD

The present invention relates to a laminate film excellent in gas barrier properties and bending properties, an electronic device member including the laminate film, and an electronic device equipped with the electronic device member.

### BACKGROUND ART

Recently, for displays such as a liquid crystal display and electroluminescence (EL) display, there is used a so-called gas barrier film configured by laminating a gas barrier layer on a transparent plastic film, in place of a glass plate, as a substrate having an electrode to actualize thin thickness, lightweight, flexibility and the like.
For example, in Patent Literature 1, there is described a gas barrier film in which a specific thin film with silicon oxide as a main component is formed at least on one surface of a base.

### CITATION LIST

### PATENT LITERATURE

Patent Literature 1: JP-A-8-224825

### SUMMARY OF INVENTION

### TECHNICAL PROBLEM

As described in Patent Literature 1, usually, gas barrier films excellent in gas barrier properties have a gas barrier layer containing an inorganic compound such as silicon oxide.
However, such gas barrier layers tended to show inferior bending properties, and, when the gas barrier film was bent, the gas barrier layer was broken to occasionally deteriorate largely gas barrier properties.
The present invention has been made in consideration of the actual condition, and the subject is to provide a laminate film that is excellent in gas barrier properties and bending properties, an electronic device member including the laminate film, and an electronic device equipped with the electronic device member.

### SOLUTION TO PROBLEM

We, the present inventors studied intensively about laminate films having at least a base and a gas barrier layer, to solve the above-described problem. As the result, we found that a laminate film excellent in gas barrier properties and bending properties could be obtained efficiently by designing a modulus of elasticity and thickness of respective layers of a gas barrier layer so that elongation strain (%) of the gas barrier layer calculated on the basis of the modulus of elasticity and thickness of respective layers configuring the laminate film became a specific value or less, to thereby complete this invention.
Thus, according to the present invention, following [1] a laminate film, [2] an electronic device member, and [3] an electronic device are provided.

[1] A laminate film including at least a base and a gas barrier layer, wherein, in a case where the laminate film is bent so as to generate tensile stress in the gas barrier layer, elongation strain (ε) generated in the gas barrier layer, which is calculated by a following formula (1), is 0.8% or less.

$$\varepsilon = (T-\lambda) / \{(3\times10^{-3})+\lambda\} \times 100 \qquad (1)$$

[T is a distance [m] from a surface farthest from the gas barrier layer to a lower surface of the gas barrier layer in a thickness direction of the laminate film, and λ is a value derived by a following formula (2).]

$$\lambda = \frac{\sum_{i=1}^{n} E_i ({h_i}^2 - {h_{i-1}}^2)}{2 \sum_{i=1}^{n} E_i t_i} \qquad (2)$$

[$h_i$ represents a distance [m] from a surface (reference surface) farthest from the gas barrier layer to an upper surface of an i-th layer. $t_i$ represents a thickness [m] of the i-th layer. $E_i$ represents a modulus of elasticity [Pa] of the i-th layer. n represents a layer number of the laminate film.]

[2] The laminate film according to [1], further including a layer selected from the group consisting of a transparent electrode layer, an organic semiconductor layer, a TFT (Thin Film Transistor) layer, a touch sensor layer, a hard coat layer, a polarizing plate layer, a tackifier layer and an adhesive layer.

[3] An electronic device member including the laminate film according to [1] or [2].

[4] An electronic device equipped with the electronic device member according to [3].

ADVANTAGEOUS EFFECTS OF INVENTION

According to the present invention, there are provided a laminate film excellent in gas barrier properties and bending properties, an electronic device member including this laminate film, and an electronic device equipped with this electronic device member.

BRIEF DESCRIPTION OF DRAWINGS

Fig. 1(a) is a schematic view showing an example of a laminate film. Fig. 1(b) is a schematic view of a state in which the laminate film is bent so as to generate tensile stress in a gas barrier layer.

Fig. 2 is a schematic view of the laminate film for explaining meaning of the formula (2).

Fig. 3 is a schematic view for explaining the formula (1).

DESCRIPTION OF EMBODIMENTS

Hereinafter, the present invention will be explained in detail, itemized into 1) a laminate film, and 2) an electronic device member and an electronic device.

1) Laminate film

The laminate film of the present invention is a laminate film having at least a base and a gas barrier layer, wherein elongation strain (ε) generated in the gas barrier layer when the laminate film is bent so that tensile stress is generated in the gas barrier layer is 0.8% or less, the elongation strain being calculated by the formula (1).

A base configuring the laminate film is not particularly limited, as long as it can support the gas barrier layer.

As the base, a resin film can be used.

A resin component of the resin film includes polyimide, polyamide, polyamideimide, polyphenylene ether, polyetherketone, polyether ether ketone, polyolefin, polyester, polycarbonate, polysulfone, polyethersulfone, polyphenylene sulfide, acrylic-based resins, cycloolefin-based polymers, aromatic-based polymers, or the like.

These resin components can be used in one kind alone, or two or more kinds in combination.

Among these, from a fact of excellent transparency and versatility, polyimide, polyester, polysulfone and polycarbonate are preferable.

Polyimide includes, one obtained by imidizing polyamide acid that is a reaction product of aromatic tetracarboxylic acids and aromatic diamines.

Aromatic tetracarboxylic acids include pyromellitic acid, 3,3',4,4'-biphenyltetracarboxylic acid, 2,3',3,4'-biphenyltetracarboxylic acid, 3,3',4,4'-benzophenonetetracarboxylic acid, 2,3,6,7-naphthalenetetracarboxylic acid, 2,2-bis(3,4-dicarboxyphenyl)propane, pyridine-2,3,5,6-tetracarboxylic acid, and acid anhydrides thereof.

Aromatic diamines include para-phenylenediamine, meta-phenylenediamine, benzidine, para-xylylenediamine, 4,4'-diaminodiniphenyl ether, 3,4'-diaminodiphenyl ether, 4,4'-diaminodiphenylmethane, 4,4'-diaminodiphenyl sulfone, 3,3 '-dimethyl-4,4'-diaminodiphenylmethane, 1,5-diaminonaphthalene, 3,3'-dimethoxybenzidine, and 1,4-bis(3-methyl-5-aminophenyl)benzene.

Polyester is a polycondensate of a polycarboxylic acid (dicarboxylic acid) and polyalcohol (diol).

Dicarboxylic acid compounds include terephthalic acid, isophthalic acid, phthalic acid, 1,4-naphthalenedicarboxylic acid, 1,5-naphthalenedicarboxylic acid, 2,6-naphthalenedicarboxylic acid, 4,4'-diphenyldicarboxylic acid, 4,4'-diphenyletherdicarboxylic acid, 4,4'-diphenylsulfonedicarboxylic acid, and the like.

Diol compounds include ethylene glycol, 1,2-propanediol, 1,3-propanediol, neopentyl glycol, 1,3-butanediol, 1,4-butanediol, 1,5-pentanediol, 1,6-hexanediol, 1,2-cyclohexanedimethanol, 1,3 -cyclohexanedimethanol, 1,4-cyclohexanedimethanol, diethylene glycol, triethylene glycol, polyalkylene glycol, 2,2'-bis(4'-β-hydroxyethoxyphenyl)propane, and the like.

Specific examples of polyesters include polyethylene terephthalate, polybutylene terephthalate, polyethylene naphthalate, polyarylate, and the like.

Polysulfone includes a reaction product of a dihydroxy compound and bis(halophenyl)sulfone.

Dihydroxy compounds include bisphenol A (2,2-bis(4-hydroxyphenyl)propane, 1,4-dihydroxy benzene, 1,3-dihydroxy benzene, 4,4'-biphenol, 3,3'-biphenol, 3,4'-biphenol, and the like.

Bis(halophenyl)sulfone includes 4,4'-difluorodiphenylsulfone, 4,4' -dichlorodiphenylsulfone, 4,4' -dibromodiphenylsulfone, 3,4'-difluorodiphenylsulfone, 3,4'-dichlorodiphenylsulfone, 3,4' -dibromodiphenylsulfone, 3,3' -difluorodiphenylsulfone, 3,3'-dichlorodiphenylsulfone, 3,3'-dibromodiphenylsulfone, and the like.

Polycarbonate includes a reaction product of an aromatic divalent phenol compound and a carbonate precursor.

Aromatic divalent phenol compounds include 2,2-bis(4-hydroxyphenyl)propane, 9,9-bis(4-hydroxyphenyl)fluorene, 4,4'-biphenol, 4,4'-dihydroxybiphenyl ether, 2,2-bis(3-methyl-4-hydroxyphenyl)propane, 2,2-bis(3-bromo-4-hydroxyphenyl)propane, 2,2-bis(4-hydroxy-3,5-dimethylphenyl)propane, bis(4-hydroxyphenyl)methane, 1,1-bis(4-hydroxyphenyl)ethane, 2,2-bis(4-hydroxyphenyl)butane, 2,2-bis(4-hydroxy-3,5-dimethylphenyl)butane, 2,2-bis(4-hydroxy-3,5-dipropylphenyl)propane, 1,1-bis(4-hydroxyphenyl)cyclohexane, 1,1-bis(4-hydroxyphenyl)-3,3,5-trimethylcyclohexane, and the like.

Carbonate precursors include phosgene, bischloroformates of above-described divalent phenols, diphenyl carbonate, di-p-tolyl carbonate, phenyl-p-tolyl carbonate, di-p-chlorophenyl carbonate, dinaphthyl carbonate, and the like.

Although thickness of the resin film is not particularly limited, it is usually 1 - 100 μm, preferably 5 - 70 μm, and more preferably 10 - 60 μm.

A modulus of tensile elasticity of the resin film is usually 0.1 - 100 GPa and preferably 0.5 - 10 GPa.

The modulus of tensile elasticity of the resin film can be measured according to a method described in Example.

The resin film may contain various kinds of additives. Additives include an ultraviolet absorber, an antistatic agent, a stabilizer, an oxidation inhibitor, a plasticizer, a lubricant, a filler, a coloring pigment, and the like. A content of these additives may suitably be determined in accordance with a purpose.

The resin film can be obtained by preparing a resin composition containing predetermined components and molding the same in a film shape. The molding method is not particularly limited, and known methods such as a casting method and a melt-extrusion method can be utilized.

The gas barrier layer constituting the laminate film is a layer having a property of suppressing transmission of a gas such as oxygen or water vapor (gas barrier property).

Thickness of the gas barrier layer is usually 1 - 2000 nm, more preferably 3 - 1000 nm, and furthermore preferably 5 - 500 nm.

Modulus of elasticity of the gas barrier layer is usually 0.1 - 500 GPa and preferably 1 - 100 GPa.

The modulus of elasticity of the gas barrier layer can be measured according to a method described in Example.

Examples of the gas barrier layer include an inorganic vapor-deposited film, a layer containing a polymer compound (hereinafter, may be referred to as a "polymer layer") whose surface is modified, and the like [in this case, a gas barrier layer means not only a modified region, but also a "polymer layer containing a modified region"].

Inorganic vapor-deposited films include vapor-deposited films of inorganic compounds and metals.

Raw materials of vapor-deposited films of inorganic compounds include inorganic oxides such as silicon oxide, aluminum oxide, magnesium oxide, zinc oxide, indium oxide and tin oxide; inorganic nitrides such as silicon nitride, aluminum nitride and titanium nitride; inorganic carbides; inorganic sulfides; inorganic oxynitrides such as silicon oxynitride; inorganic oxycarbides; inorganic nitridecarbides; inorganic oxinitridecarbides, and the like.

Raw materials of vapor-deposited films of metals include aluminum, magnesium, zinc, tin, and the like.

These can be used in one kind alone, or in two or more kinds in combination.

Among these, from the viewpoint of a gas barrier property, an inorganic vapor-deposited film derived from an inorganic oxide, inorganic nitride or metal as a raw material is preferable, and from the viewpoint of transparency in addition, an inorganic vapor-deposited film derived from an inorganic oxide or inorganic nitride as a raw material is preferable.

Methods for forming an inorganic vapor-deposited film include PVD (physical vapor deposition) methods such as a vacuum deposition method, a sputtering method and an ion plating method, CVD methods such as a thermal CVD (chemical vapor deposition) method, a plasma CVD method and a photo-CVD method, and an atomic layer deposition

(ALD) method.

Thickness of the inorganic vapor-deposited film varies depending on an inorganic compound or a metal to be used, and lies in a range of preferably 1 - 2000 nm, more preferably 3 - 1000 nm, and furthermore preferably 5 - 500 nm, from the viewpoint of gas barrier properties and handling properties.

In a gas barrier layer, which is formed by modifying a surface of a polymer layer, polymer compounds to be used include silicon-containing polymer compounds, polyimide, polyamide, polyamide-imide, polyphenylene ether, polyetherketone, polyether ether ketone, polyolefin, polyester, polycarbonate, polysulfone, polyethersulfone, polyphenylene sulfide, polyarylate, acrylic-based resins, alicyclic hydrocarbon-based resins, aromatic-based polymers, and the like.

These polymer compounds can be used in one kind alone, or in two or more kinds in combination.

The polymer layer may contain other component in addition to a polymer compound in a range that does not inhibit the purpose of the present invention. The other component includes a curing agent, an aging inhibitor, a light stabilizer, a flame retardant, or the like.

The content of the polymer compound in the polymer layer is preferably not less than 50% by mass, and more preferably not less than 70% by mass, because a gas barrier layer having a more excellent gas barrier property can be formed.

Although thickness of the polymer layer is not particularly limited, it lies in a range of usually 20 nm to 50 μm, preferably 30 nm to 1 μm, and more preferably 40 nm to 500 nm.

A polymer layer can be formed, for example, by coating a liquid obtained by dissolving or dispersing a polymer compound in an organic solvent onto a predetermined layer by a known coating method and drying the obtained coated film.

Organic solvents include aromatic hydrocarbon-based solvents such as benzene and toluene; ester-based solvents such as ethyl acetate and butyl acetate; ketone-based solvents such as acetone, methyl ethyl ketone and methyl isobutyl ketone; aliphatic hydrocarbon-based solvents such as n-pentane, n-hexane and n-heptane; alicyclic hydrocarbon-based solvents such as cyclopentane and cyclohexane; and the like.

These solvents can be used in one kind alone, or in two or more kinds in combination.

Coating methods include a bar-coating method, a spin-coating method, a dipping method, a roll-coating method, a gravure-coating method, a knife-coating method, an air knife-coating method, a roll knife-coating method, a die-coating method, a screen printing method, a spray-coating method, a gravure offset method, and the like.

Methods for drying a coated film include conventionally known drying methods such as hot air drying, hot roll drying and infrared ray irradiation. Heating temperature is usually 80 - 150°C, and heating time is usually from several tens of seconds to several tens of minutes.

As methods for modifying a surface of a polymer layer, there are an ion implantation treatment, a plasma treatment, an ultraviolet ray irradiation treatment, a heat treatment, and the like.

The ion implantation treatment is a method of implanting accelerated ions into a polymer layer to thereby modify the polymer layer, as described later.

The plasma treatment is a method of exposing a polymer layer in plasma to thereby modify the polymer layer. For example, the plasma treatment can be performed according to the method described in JP-A-2012-106421.

The ultraviolet ray irradiation treatment is a method of irradiating a polymer layer with ultraviolet rays to thereby modify the polymer layer. For example, an ultraviolet ray modification treatment can be performed according to the method described in JP-A-2013-226757.

Among these gas barrier layers, because of more excellent gas barrier properties, layers obtained by subjecting a layer containing a silicon-containing polymer compound to an ion implantation treatment is preferable.

Silicon-containing polymer compounds include polysilazane-based compounds, polycarbosilane-based compounds, polysilane-based compounds, polyorganosiloxane-based compounds, poly(disilanylenephenylene)-based compounds, poly(disilanyleneethynylene)-based compounds and the like, and polysilazane-based compounds are more preferable.

Polysilazane-based compounds are compounds having a repeating unit containing a -Si-N- bond (silazane bond) in a molecule. Specifically, compounds having a repeating unit represented by a formula (3) are preferable.

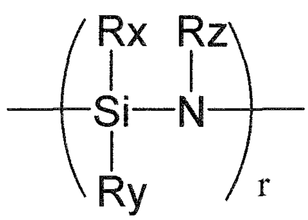

(3)

Moreover, although number average molecular weight of a polysilazane-based compound to be used is not

particularly limited, it is preferably 100 - 50,000.

In the formula (3), r represents an arbitrary natural number. Rx, Ry and Rz each independently represents a hydrogen atom, and a non-hydrolyzable group such as an unsubstituted or substituted alkyl group, an unsubstituted or substituted cycloalkyl group, an unsubstituted or substituted alkenyl group, an unsubstituted or substituted aryl group or alkylsilyl group.

Examples of alkyl groups of the unsubstituted or substituted alkyl groups include alkyl groups having 1 - 10 carbon atoms such as a methyl group, an ethyl group, a n-propyl group, an isopropyl group, a n-butyl group, an isobutyl group, a sec-butyl group, a t-butyl group, a n-pentyl group, an isopentyl group, a neopentyl group, a n-hexyl group, a n-heptyl group and a n-octyl group.

Examples of cycloalkyl groups of the unsubstituted or substituted cycloalkyl groups include cycloalkyl groups having 3 - 10 carbon atoms such as a cyclobutyl group, a cyclopentyl group, a cyclohexyl group and a cycloheptyl group.

Examples of alkenyl groups of the unsubstituted or substituted alkenyl groups include alkenyl groups having 2 - 10 carbon atoms such as a vinyl group, a 1-propenyl group, a 2-propenyl group, a 1-butenyl group, a 2-butenyl group and a 3-butenyl group.

Substituents of the alkyl group, cycloalkyl group and alkenyl group include halogen atoms such as a fluorine atom, a chlorine atom, a bromine atom and an iodine atom; a hydroxyl group; a thiol group; an epoxy group; a glycidoxy group; a (meta)acryloyloxy group; unsubstituted or substituted aryl groups such as a phenyl group, a 4-methylphenyl group and a 4-chlorophenyl group; and the like.

Examples of aryl groups of unsubstituted or substituted aryl groups include aryl groups having 6 - 15 carbon atoms such as a phenyl group, 1-naphthyl group and 2-naphthyl group.

Substituents of the aryl group include halogen atoms such as a fluorine atom, a chlorine atom, a bromine atom and an iodine atom; alkyl groups having 1 - 6 carbon atoms such as a methyl group and an ethyl group; alkoxy groups having 1 - 6 carbon atoms such as a methoxy group and an ethoxy group; a nitro group; a cyano group; a hydroxyl group; a thiol group; an epoxy group; a glycidoxy group; a (meta)acryloyloxy group; unsubstituted or substituted aryl groups such as a phenyl group, a 4-methyl phenyl group and a 4-chlorophenyl group; and the like.

Alkylsilyl groups include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, an ethylsilyl group and the like.

Among these, as Rx, Ry, Rz, a hydrogen atom, an alkyl group having 1 - 6 carbon atoms, or a phenyl group is preferable, and a hydrogen atom is particularly preferable.

The polysilazane-based compound having the repeating unit represented by the formula (3) may be either of an inorganic polysilazane in which all of Rx, Ry and Rz are hydrogen atoms, or an organic polysilazane in which at least one of Rx, Ry and Rz is not a hydrogen atom.

Moreover, in the invention, as a polysilazane-based compound, a modified product of polysilazane may also be used. Examples of modified products of polysilazane include those described in JP-A-62-195024, JP-A-2-84437, JP-A-63-81122, JP-A-1-138108, JP-A-2-175726, JP-A-5-238827, JP-A-5-238827, JP-A-6-122852, JP-A-6-306329, JP-A-6-299118, JP-A-9-31333, JP-A-5-345826, JP-A-4-63833, or the like.

As a polysilazane-based compound among these, from the viewpoint of easy availability and capability of forming an ion-implanted layer having excellent gas barrier properties, perhydropolysilazane in which all of Rx, Ry and Rz are hydrogen atoms is preferable.

Moreover, as a polysilazane-based compound, a commercially available product sold on the market as a glass coating material and the like can also be used as it is.

Polysilazane-based compounds can be used in one kind alone, or in two or more kinds in combination.

Ions to be implanted into a polymer layer include ions of rare gases such as argon, helium, neon, krypton and xenon; ions of fluorocarbon, hydrogen, nitrogen, oxygen, carbon dioxide, chlorine, fluorine and sulfur; ions of alkane-based gases such as methane and ethane; ions of alkene-based gases such as ethylene and propylene; ions of alkadiene-based gases such as pentadiene and butadiene; ions of alkyne-based gases such as acetylene; ions of aromatic hydrocarbon-based gases such as benzene and toluene; ions of cycloalkane-based gases such as cyclopropane; ions of cycloalkene-based gases such as cyclopentene; ions of metals; ions of organic silicon compounds; and the like.

These ions can be used in one kind alone, or in two or more kinds in combination.

Among these, since ions can be implanted more easily and simply, and a gas barrier layer may be formed having more excellent gas barrier properties, ions of rare gases such as argon, helium, neon, krypton, xenon and the like are preferable.

An implantation amount of ions can be suitably determined in accordance with an intended purpose (necessary gas barrier properties, transparency, etc.) of a laminate film.

Implanting methods of ions include a method of irradiation with ions accelerated by an electric field (ion beam), a method of implanting ions in plasma, and the like. Among these, the latter method of implanting ions in plasma (plasma ion implantation method) is preferable because an intended gas barrier layer can be obtained in an easy and simple way.

A plasma ion implantation method can be performed, for example, by generating plasma under an atmosphere

containing a plasma-generating gas such as a rare gas and applying negative high voltage pulse to a polymer layer to thereby implant ions (positive ions) in the plasma into a surface part of the polymer layer. The plasma ion implantation method can be performed, more specifically, by methods described in WO 2010/107018 brochure or the like.

Thickness of a region into which ions are to be implanted by ion implantation can be controlled by implantation conditions such as a kind of the ion, applied voltage and treatment time and may be determined in accordance with the thickness of a polymer layer, an intended purpose of a laminate film and the like, and is usually 10 to 400 nm.

A fact that ions have been implanted can be confirmed by performing measurement of elemental analysis at a position approximately 10 nm from the surface of the polymer layer, using X-ray photoelectron spectroscopy (XPS).

The laminate film of the present invention has elongation strain (ε) to be generated in a gas barrier layer, is 0.8% or less, preferably more than 0 to 0.4% or less, and more preferably more than 0 to 0.2% or less, the elongation strain (ε) being calculated by the following formula (1) when the laminate film is bent so that tensile stress is generated in the gas barrier layer.

$$\varepsilon = (T-\lambda) / \{(3\times10^{-3})+\lambda\}\times100 \quad (1)$$

In the formula (1), T is a distance [m] from a surface (reference surface) farthest from a gas barrier layer to a lower surface of the gas barrier layer (the surface of the gas barrier layer on the reference surface side) in a thickness direction of the laminate film, and λ is a value derived using the following formula (2).

$$\lambda = \frac{\sum_{i=1}^{n} E_i({h_i}^2 - {h_{i-1}}^2)}{2\sum_{i=1}^{n} E_i t_i} \quad (2)$$

In the formula (2), λ represents a distance [m] from the reference surface up to a hypothetical plane (α) in the laminate film, in the thickness direction of the laminate film.

The hypothetical plane (α) is a surface configured of points at which neither compression stress nor tensile stress is generated when the laminate film is bent.

For example, in a case where a laminate film (1) having a layer A1 (2) and a layer A2 (3) as shown in Fig. 1(a) is bent so that the layer A1 (2) lies inside as shown in Fig. 1 (b), as shown by an arrow, compression stress (hollow arrow) is generated in the inner side of the laminate film (1) and tensile stress (hollow arrow) is generated in the outer side thereof. Then, at a point in the thickness direction, neither compression stress nor tensile stress is generated. A set of such points where neither compression stress nor tensile stress is generated is the hypothetical plane (α) (4).

A position of the hypothetical plane (α) can be determined on the basis of a modulus of elasticity and thickness of each layer. Specifically, the position of the hypothetical plane (α) can be calculated according to above-described formula (2).

For example, in a laminate film (5) of a three-layer structure configured of a layer B1 (6), a layer B2 (7) and a layer B3 (8) as shown in Fig. 2, in a case where a gas barrier layer is the layer B3 (8), the surface of the layer B1 (6) is a reference surface (9). Then, the distance λ between the reference surface (9) and a hypothetical plane (α) (10) is calculated according to the formula (2).

In the formula (2), $h_i$ represents a distance [m] from the layer configuring the reference surface up to the upper surface of an i-th layer. $t_i$ represents a thickness [m] of the i-th layer. $E_i$ represents a modulus of elasticity [Pa] of the i-th layer. In this case, the layer having the reference surface is also included (that is, the layer having the reference surface is the first (i = 1)).

n represents a layer number of a laminate film. For example, in a case of a laminate film composed of only a base and a gas barrier layer, n is 2 (n = 2); and in a case of a laminate film having a base, a gas barrier layer and a hard coat layer, n is 3 (n = 3).

A laminate film, which gives ε of 0.8% or less as a result of substitution of λ obtained according to the formula (2) in the formula (1), shows sufficient bending resistance even when the film is bent around a round bar of 6 mm in diameter.

The laminate film of the present invention has elongation strain (ε) that is generated in the gas barrier layer and is calculated according to the formula (1) below and is 0.8% or less, when the laminate film is bent so that tensile stress is generated in the gas barrier layer.

Here, "the laminate film is bent so that tensile stress is generated in the gas barrier layer" means that, as shown

in Fig. 3, the laminate film of the present invention is bent around a round bar {diameter of 6 mm} so as to go along a semicircle (upper side) shape of the round bar cross-section.

The formula (1) represents, in this case, a ratio of a sum of the radius of the round bar and thickness of a part of the laminate film in which compression stress is generated to the thickness of the laminate film in which tensile stress is generated.

In other words, as shown in Fig. 3, in a case where a laminate film (11) (in Fig. 3, the layer structure of the laminate film is omitted) is bent around a round bar (12) having diameter of 6 mm (that is, the radius is $3 \times 10^{-3}$ m), directions of generated stresses are different at one side of a hypothetical plane ($\alpha$) (13) from the other side. Here, the denominator in the formula (1) corresponds to the length of a in Fig. 3, and the numerator in the formula (1) corresponds to the length of b in Fig. 3.

As a consequence of division into the part where compression stress is generated and the part where tensile stress is generated in this way, it is possible to express strain in the elongation direction of the gas barrier layer surface in the laminate film more accurately. Then, as shown in Example, in a case where (length of b)/ (length of a) $\times$ 100 (that is, elongation strain ($\varepsilon$) in the formula (1)) is 0.8% or less, sufficient bending resistance is shown against bending corresponding to the case where bending is performed around a round bar of 6 mm in diameter.

The laminate film of the present invention is a laminate film having at least a base and a gas barrier layer, in which a layer number, material and thickness of respective layers are not particularly limited, as long as an elongation strain ($\varepsilon$) calculated using the formula (1) is 0.8% or less. A lower limit of the elongation strain ($\varepsilon$) usually exceeds 0%.

A laminate film whose elongation strain ($\varepsilon$) is 0.8% or less tends to be obtained easily by designing respective layers so as to give large $\lambda$. For example, a laminate film whose elongation strain ($\varepsilon$) is 0.8% or less tends to be obtained easily by thinner thickness of a layer such as a base, which lies on the inner side when the film is bent, to give a smaller modulus of elasticity.

In a case where the laminate film of the present invention has a layer other than the gas barrier layer and base, such a layer includes a functional layer such as a transparent electrode layer, an organic semiconductor layer, a TFT (Thin Film Transistor) layer, a touch sensor layer and a polarizing plate layer; a hard coat layer; a tackifier layer; an adhesive layer; or the like. The laminate film of the present invention may have two or more kinds of these layers.

These layers can be formed by a known method.

Examples of layer configurations of the laminate film of the present invention include (base)/ (gas barrier layer), (base)/ (gas barrier layer)/ (tackifier layer), (base)/ (hard coat layer)/ (gas barrier layer), (base)/ (hard coat layer)/ (functional layer)/ (gas barrier layer)/ (tackifier layer), and the like, but are not limited to these.

The laminate film of the present invention has excellent bending resistance. Here, "bending resistance" means properties such that, even in a case where a laminate film is bent as shown in Fig. 3, a crack or the like does not occur in the laminate film and a water vapor transmission rate does not deteriorate.

The fact that the laminate film of the present invention has excellent bending resistance can be confirmed from the fact that a water vapor transmission rate is little changed before and after a bending test described in Example to be described later. In the laminate film of the present invention, a rate of change of a water vapor transmission rate ($\Delta$WVTR) before and after the bending test described in Example to be described later is usually from more than 100% to 300% or less, and preferably from more than 100% to 200% or less. Meanwhile, $\Delta$WVTR can be obtained according to the formula below.

$$\Delta\text{WVTR [\%]} = (\text{WVTR after bending/ WVTR before bending}) \times 100$$

2) Electronic device member and electronic device

The electronic device member of the present invention is characterized by including the laminate film of the present invention. Accordingly, the electronic device member of the present invention has excellent gas barrier properties, and therefore can prevent deterioration of an element due to gases such as water vapor.

The electronic device member of the present invention is preferably used as a member of displays such as a liquid crystal display and an EL display.

The electronic device of the present invention is equipped with the electronic device member of the present invention. Specific examples include a liquid crystal display, an organic EL display, an inorganic EL display, electric paper, a solar cell and the like.

The electronic device of the present invention is equipped with the electronic device member including the laminate film of the present invention and, therefore, failures are unlikely to occur due to penetration of water vapor or the like and is excellent in bending properties.

EXAMPLES

Hereinafter, the present invention will be described in more detail, while citing Examples. However, the present invention is not limited at all to following Examples.

"Part" and "%" in each Example are based on mass, unless otherwise noted.

[Measurement of modulus of elasticity of resin film]

A modulus of tensile elasticity at 23°C of a resin film used in Examples or Comparative Examples was measured in conformity with JIS K7127 using a tensile testing machine (TENSILON RTA-100, manufactured by ORIENTEC Co., LTD).

[Measurement of modulus of elasticity of gas barrier layer]

As a measurement sample of a modulus of elasticity of a gas barrier layer, a sample, in which a gas barrier layer of 100 nm in thickness had been formed on a silicon wafer by a method similar to the method in each of Examples or Comparative Examples, was used.

For the obtained measurement sample, a modulus of elasticity at 23°C was measured with a nanoindenter (Nanoindentor DCM, manufactured by MTS Systems Corporation) to obtain a modulus of elasticity at a depth position of 10 nm from the surface of the gas barrier layer. (shape of indenter tip: triangular pyramid, vibration frequency: 45 Hz, drift speed: 0.5 nm/sec)

[Evaluation of bending test]

Using a Tension-Free U-shape Folding Testing machine (DLDMLH-FS, manufactured by YUASA SYSTEM Co., Ltd.), a bending test was performed under conditions of 23°C, 30 rpm in bending rate, 10000 in number of bending times, and 6 mm in bending diameter.

[Measurement of water vapor transmission rate]

Water vapor transmission rates (WVTR) of a laminate film before and after the bending test were measured under conditions of 40°C and relative humidity of 90%, using a water vapor transmission rate measurement apparatus (AQUATRAN, manufactured by MOCON Inc.).

Moreover, on the basis of the obtained WVTR, a rate of change (ΔWVTR) of the water vapor transmission rate after the bending test was calculated from a formula below.

$$\Delta \text{WVTR [\%]} = (\text{WVTR after bending/ WVTR before bending}) \times 100$$

[Example 1]

A surface of a polyimide (PI) film (Kapton 50H, thickness 12.5 μm, manufactured by DU PONT-TORAY CO., LTD.) as a base was subjected to a plasma treatment (treatment conditions: oxygen gas 10 ccm, 30 sec, RIE mode) using a plasma cleaner (PDC210, manufactured by Yamato Material Co., Ltd.).

Subsequently, on the plasma-treated surface, a gas barrier layer composed of silicon nitride of 100 nm in thickness was formed by a sputtering method to give a laminate film. The WVTR of the obtained laminate film was 0.008 $g/(m^2 \cdot day)$.

[Example 2]

The procedure in Example 1 was repeated except for using a polyimide film (Kapton 100H, thickness 25 μm, manufactured by DU PONT-TORAY CO., LTD.) as a base to give a laminate film.

[Example 3]

The procedure in Example 1 was repeated except for using a polyimide film (Kapton 200H, thickness 50 μm, manufactured by DU PONT-TORAY CO., LTD.) as a base to give a laminate film.

[Example 4]

The procedure in Example 1 was repeated except for forming a gas barrier layer composed of silicon oxide of 100 nm in thickness by a sputtering method to give a laminate film. The WVTR of the obtained laminate film was 0.031 g/($m^2$ ·day).

[Example 5]

A surface of a polyimide film (Kapton 50H, thickness 12.5 μm, manufactured by DU PONT-TORAY CO., LTD.) as a base was subjected to a plasma treatment (treatment conditions: oxygen gas 10 ccm, 30 sec, RIE mode) using a plasma cleaner (PDC210, manufactured by Yamato Material Co., Ltd.).

Subsequently, a polysilazane compound (a coating agent having perhydropolysilazane as a main component (AQUAMICA NL-110-20, manufactured by Merck Performance Materials)) was coated to the plasma treated surface by a spin coating method, and the obtained coted film was heated at 120°C for 1 min to form a layer of 100 nm in thickness (polysilazane layer) containing perhydro-polysilazane.

Next, using a plasma ion implantation apparatus (RF source: "RF" 56000, manufactured by JEOL Ltd., high voltage pulse source: PV-3-HSHV-0835, manufactured by Kurita Manufacturing Co., Ltd.), ions derived from argon gas were implanted into the surface of the polysilazane layer under conditions of 100 sccm in gas flow rate, 0.5% in Duty ratio, -10 kV in applied DC voltage, 1000 Hz in frequency, 1000 W in applied RF power, 0.2 Pa in inside pressure, 5 μsec in DC pulse width and 200 sec in treatment time to form a gas barrier layer, and a laminate film was obtained. The WVTR of the obtained laminate film was 0.006 g/($m^2$ ·day).

[Example 6]

The procedure in Example 1 was repeated except for using a polyethylene terephthalate (PET) film (T-100, thickness 12 μm, manufactured by Mitsubishi Plastics, Inc.) as a base to give a laminate film.

[Example 7]

The procedure in Example 1 was repeated except for using a polyethylene terephthalate film (T-100, thickness 25 μm, manufactured by Mitsubishi Plastics, Inc.) as a base to give a laminate film.

[Example 8]

The procedure in Example 1 was repeated except for using a polyethylene terephthalate film (T-100, thickness 50 μm, manufactured by Mitsubishi Plastics, Inc.) as a base to give a laminate film.

[Example 9]

The procedure in Example 1 was repeated except for using a polyethylene naphthalate (PEN) film (Teonex Q51, thickness 12 μm, manufactured by Teijin DuPont Films Japan Limited) as a base to give a laminate film.

[Example 10]

The procedure in Example 1 was repeated except for using a polyethylene naphthalate film (Teonex Q51, thickness 25 μm, manufactured by Teijin DuPont Films Japan Limited) as a base to give a laminate film.

[Example 11]

The procedure in Example 1 was repeated except for using a polyethylene naphthalate film (Teonex Q51, thickness 50 μm, manufactured by Teijin DuPont Films Japan Limited) as a base to give a laminate film.

[Example 12]

Polysulfone (PSF)-based resin pellets (ULTRASON F5023, Tg: 180°C, manufactured by BASF Ltd.) were dissolved in dichloromethane to prepare a solution of 15% in solid content concentration. Subsequently, the solution was coated to an untreated surface of a process sheet [polyethylene terephthalate film (PET50A-4100, thickness 50 μm, manufactured by Toyobo Co., Ltd.)] so as to give 12 μm in dry thickness by a die system, and the obtained coated

film was heated at 50°C for 30 min and then at 130°C for 1 hr to dry the coated film. The obtained dry coated film was exfoliated from the process sheet to give a polysulfone film as a base. On the base, a gas barrier layer was formed in the same way as in Example 1 to give a laminate film.

[Example 13]

The procedure in Example 12 was repeated except for changing thickness of a polysulfone film to 25 μm to give a laminate film.

[Example 14]

The procedure in Example 12 was repeated except for changing thickness of a polysulfone film to 50 μm to give a laminate film.

[Example 15]

The procedure in Example 1 was repeated except for using a polycarbonate (PC) film (PURE-ACE M5-50, thickness 50 μm, manufactured by Teijin Limited) as a base to give a laminate film.

[Example 16]

The procedure in Example 1 was repeated except for changing thickness of a gas barrier layer composed of silicon nitride to 50 nm to give a laminate film. The WVTR of the obtained laminate film was 0.020 g/($m^2$ ·day).

[Example 17]

The procedure in Example 1 was repeated except for changing thickness of a gas barrier layer composed of silicon nitride to 200 nm to give a laminate film. The WVTR of the obtained laminate film was 0.004 g/($m^2$ ·day).

[Example 18]

The procedure in Example 1 was repeated except for changing thickness of a gas barrier layer composed of silicon nitride to 300 nm to give a laminate film. The WVTR of the obtained laminate film was 0.001 g/($m^2$ ·day).

[Example 19]

A surface of a polyimide film (Kapton 50H, thickness 12.5 μm, manufactured by DU PONT-TORAY CO., LTD.) as a base was subjected to a plasma treatment (treatment conditions: oxygen gas 10 ccm, 30 sec, RIE mode) using a plasma cleaner (PDC210, manufactured by Yamato Material Co., Ltd.).

Subsequently, on the plasma-treated surface, a gas barrier layer composed of silicon oxide of 100 nm in thickness was formed by a plasma CVD method to give a laminate film. The WVTR of the obtained laminate film was 0.19 g/($m^2$ ·day).

Formation conditions of the gas barrier layer by a plasma CVD method are as follows.

Flow rate of hexamethyldisiloxane: 50 sccm
Flow rate of argon gas: 15 sccm
Flow rate of oxygen gas: 10 sccm
Inner pressure of chamber: 0.3 Pa
Power of RF source: 1000 W
Deposition time: 55 sec

[Example 20]

The procedure in Example 1 was repeated except for forming a zinc tin oxide film (ZTO film) of 100 nm in thickness as a gas barrier layer by a sputtering method to give a laminate film. The WVTR of the obtained laminate film was 0.008 g/($m^2$ ·day).

[Comparative Example 1]

The procedure in Example 1 was repeated except for using a polyimide film (Kapton 300H, thickness 75 μm, manufactured by DU PONT-TORAY CO., LTD.) as a base to give a laminate film.

[Comparative Example 2]

The procedure in Example 1 was repeated except for using a polyethylene terephthalate film (T-100, thickness 75 μm, manufactured by Mitsubishi Plastics, Inc.) as a base to give a laminate film.

[Comparative Example 3]

The procedure in Example 1 was repeated except for using a polyethylene naphthalate film (Teonex Q51, thickness 75 μm, manufactured by Teijin DuPont Films Japan Limited) as a base to give a laminate film.

[Comparative Example 4]

The procedure in Example 12 was repeated except for changing thickness of a polysulfone film to 75 μm to give a laminate film.

Details of laminate films obtained in Examples or Comparative Examples are shown in Table 1.

TABLE 1

| | Base layer | | | Barrier layer | | | Bending diameter [mm] | Elongation strain (ε) [%] | ΔWVTR [%] |
|---|---|---|---|---|---|---|---|---|---|
| | Resin component | Modulus of tensile elasticity [GPa] | Thickness [μm] | Component | Modulus of elasticity [GPa] | Thickness [nm] | | | |
| Example 1 | PI | 3.4 | 12 | $Si_3N_4$ | 112 | 100 | 6 | 0.16 | 111 |
| Example 2 | PI | 3.4 | 25 | $Si_3N_4$ | 112 | 100 | 6 | 0.37 | 100 |
| Example 3 | PI | 3.4 | 50 | $Si_3N_4$ | 112 | 100 | 6 | 0.78 | 184 |
| Example 4 | PI | 3.4 | 25 | $SiO_2$ | 51 | 100 | 6 | 0.39 | 133 |
| Example 5 | PI | 3.4 | 25 | PHPS | 32 | 100 | 6 | 0.40 | 123 |
| Example 6 | PET | 4.1 | 12 | $Si_3N_4$ | 112 | 100 | 6 | 0.17 | 110 |
| Example 7 | PET | 4.1 | 25 | $Si_3N_4$ | 112 | 100 | 6 | 0.38 | 125 |
| Example 8 | PET | 4.1 | 50 | $Si_3N_4$ | 112 | 100 | 6 | 0.79 | 108 |
| Example 9 | PEN | 7.1 | 12 | $Si_3N_4$ | 112 | 100 | 6 | 0.18 | 100 |
| Example 10 | PEN | 7.1 | 25 | $Si_3N_4$ | 112 | 100 | 6 | 0.39 | 113 |
| Example 11 | PEN | 7.1 | 50 | $Si_3N_4$ | 112 | 100 | 6 | 0.80 | 103 |
| Example 12 | PSF | 1.8 | 12 | $Si_3N_4$ | 112 | 100 | 6 | 0.13 | 120 |
| Example 13 | PSF | 1.8 | 25 | $Si_3N_4$ | 112 | 100 | 6 | 0.33 | 100 |
| Example 14 | PSF | 1.8 | 50 | $Si_3N_4$ | 112 | 100 | 6 | 0.74 | 132 |
| Example 15 | PC | 2.3 | 50 | $Si_3N_4$ | 112 | 100 | 6 | 0.76 | 103 |
| Example 16 | PI | 3.4 | 12 | $Si_3N_4$ | 112 | 50 | 6 | 0.18 | 101 |
| Example 17 | PI | 3.4 | 12 | $Si_3N_4$ | 112 | 200 | 6 | 0.13 | 112 |
| Example 18 | PI | 3.4 | 12 | $Si_3N_4$ | 112 | 300 | 6 | 0.12 | 128 |
| Example 19 | PI | 3.4 | 12 | $SiO_2$ | 11 | 100 | 6 | 0.20 | 105 |
| Example 20 | PI | 3.4 | 12 | ZTO | 23 | 100 | 6 | 0.19 | 109 |
| Comparative Example 1 | PI | 3.4 | 75 | $Si_3N_4$ | 112 | 100 | 6 | 1.19 | 2013 |
| Comparative Example 2 | PET | 4.1 | 75 | $Si_3N_4$ | 112 | 100 | 6 | 1.19 | 1856 |

(continued)

| | Base layer | | | Barrier layer | | | Bending diameter [mm] | Elongation strain (ε) [%] | ΔWVTR [%] |
|---|---|---|---|---|---|---|---|---|---|
| | Resin component | Modulus of tensile elasticity [GPa] | Thickness [μm] | Component | Modulus of elasticity [GPa] | Thickness [nm] | | | |
| Comparative Example 3 | PEN | 7.1 | 75 | $Si_3N_4$ | 112 | 100 | 6 | 1.21 | 2566 |
| Comparative Example 4 | PSF | 1.8 | 75 | $Si_3N_4$ | 112 | 100 | 6 | 1.14 | 1995 |

Followings are found from Table 1.

In laminate films in Examples 1 - 20, each of elongation strain (ε) values is 0.8% or less, and, in these laminate films, change in the water vapor transmission rate after the bending test is small.

On the other hand, in laminate films in Comparative Examples 1 - 4, each of elongation strain (ε) values exceeds 0.8%. In these laminate films, gas barrier properties greatly deteriorate after the bending test.

Reference Signs List

1. laminate film
2. layer A1
3. layer A2
4. hypothetical plane (α)
5. laminate film
6. layer B1
7. layer B2
8. layer B3
9. reference surface
10. hypothetical plane (α)
11. laminate film
12. round bar
13. hypothetical plane (α)

**Claims**

1. A laminate film comprising at least a base and a gas barrier layer, wherein, in a case where the laminate film is bent so as to generate tensile stress in the gas barrier layer, elongation strain (ε) generated in the gas barrier layer, which is calculated by a following formula (1), is 0.8% or less.

$$\varepsilon = (T-\lambda) / \{(3\times10^{-3})+\lambda\} \times 100 \qquad (1)$$

[T is a distance [m] from a surface farthest from the gas barrier layer to the gas barrier layer in a thickness direction of the laminate film, and λ is a value derived by a following formula (2) with respect to a hypothetical plane (α) in the laminate film.]

$$\lambda = \frac{\sum_{i=1}^{n} E_i({h_i}^2 - {h_{i-1}}^2)}{2\sum_{i=1}^{n} E_i t_i} \qquad (2)$$

[$h_i$ represents a distance [m] from a surface farthest from the gas barrier layer to an upper surface of an i-th layer. $t_i$ represents a thickness [m] of the i-th layer. $E_i$ represents a modulus of elasticity [Pa] of the i-th layer. n represents a layer number of the laminate film.]

2. The laminate film according to claim 1, further including a layer selected from the group consisting of a transparent electrode layer, an organic semiconductor layer, a TFT (Thin Film Transistor) layer, a touch sensor layer, a hard coat layer, a polarizing plate layer, a tackifier layer and an adhesive layer.

3. An electronic device member including the laminate film according to claim 1 or 2.

4. An electronic device equipped with the electronic device member according to claim 3.

Fig.1

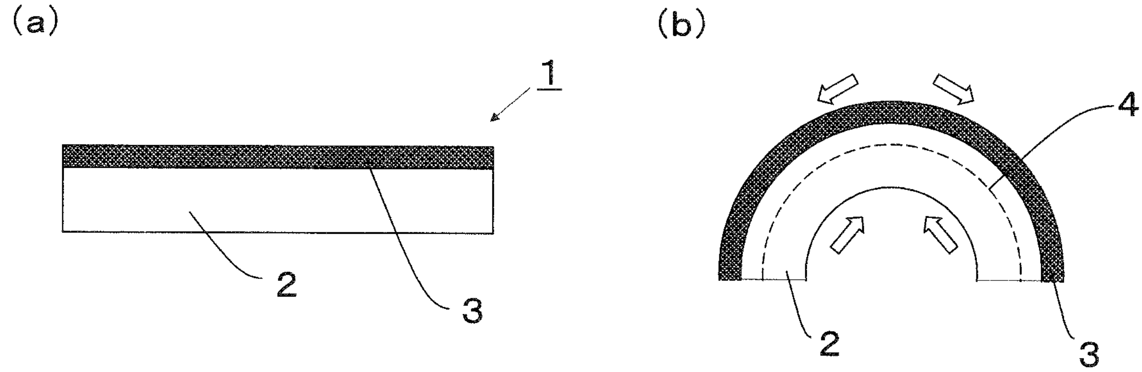


Fig.2

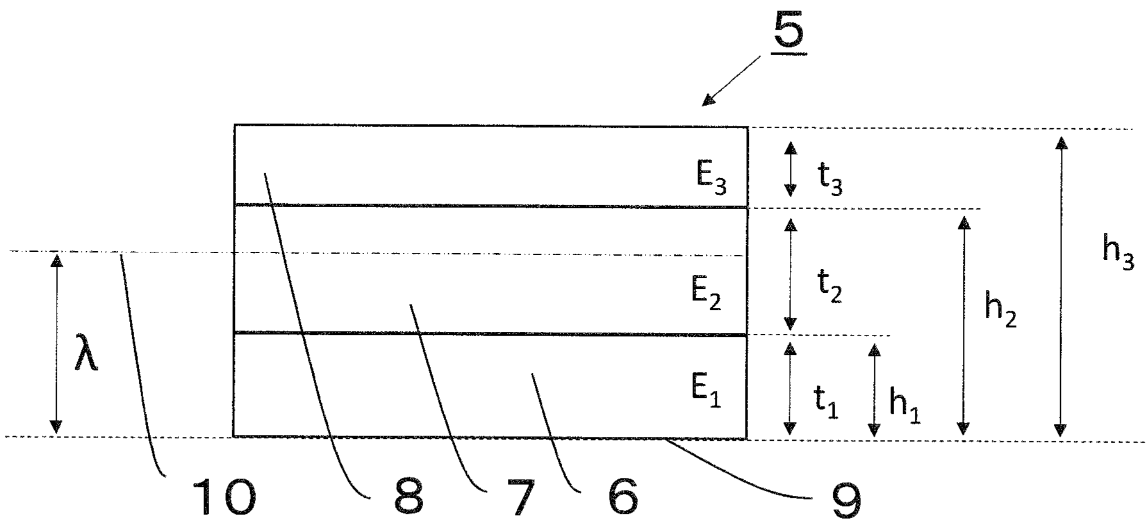

Fig.3

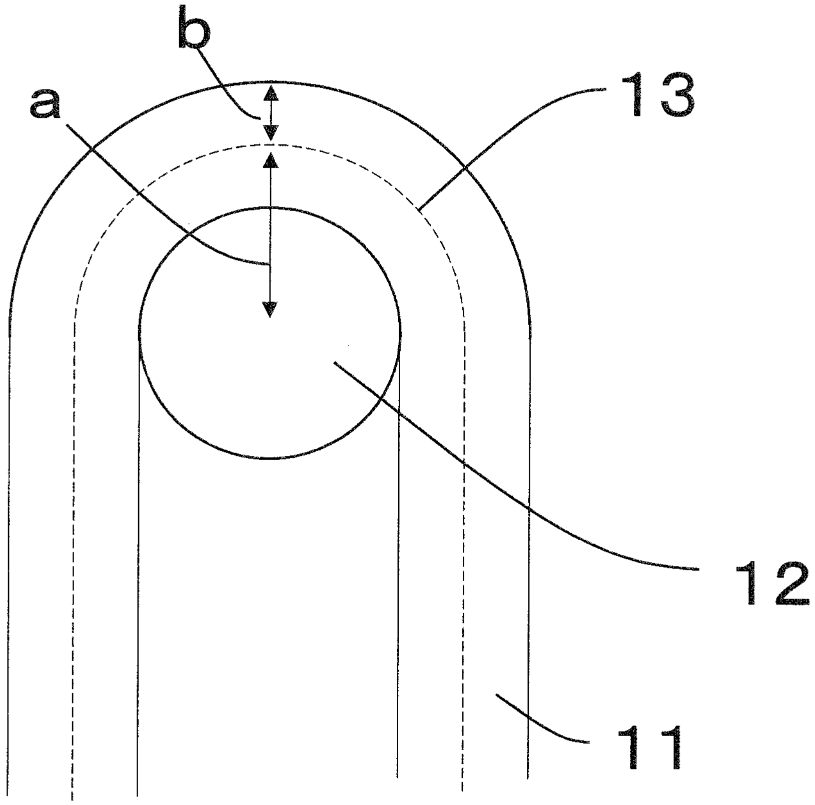

## INTERNATIONAL SEARCH REPORT

International application No.
PCT/JP2017/037972

A. CLASSIFICATION OF SUBJECT MATTER
Int.Cl. B32B7/02(2006.01)i, C23C14/06(2006.01)i, C23C16/42(2006.01)i, H01L51/50(2006.01)i, H05B33/04(2006.01)i, H05B33/28(2006.01)i, B32B9/00(2006.01)n, B32B27/00(2006.01)n

According to International Patent Classification (IPC) or to both national classification and IPC

B. FIELDS SEARCHED

Minimum documentation searched (classification system followed by classification symbols)
Int.Cl. B32B1/00-43/00, C23C14/06, C23C16/42, H01L51/50, H05B33/04, H05B33/28

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2016/039060 A1 (KONICA MINOLTA, INC.) 17 March 2016, paragraphs [0001], [0252], [0254]-[0305] & US 2017/0207415 A1, paragraphs [0001], [0347], [0350]-[0466] & KR 10-2017-0010382 A | 1-4 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 January 2018 (09.01.2018) | 23 January 2018 (23.01.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No.
PCT/JP2017/037972

C (Continuation). DOCUMENTS CONSIDERED TO BE RELEVANT

| Category* | Citation of document, with indication, where appropriate, of the relevant passages | Relevant to claim No. |
|---|---|---|
| X | WO 2013/147093 A1 (LINTEC CORP.) 03 October 2013, claims, paragraphs [0155]-[0166], [0176] & US 2015/0064429 A1, claims, paragraphs [0193]-[0206], [0217]-[0218] & EP 2832539 A1 & CN 104220254 A & KR 10-2014-0144690 A & TW 201404601 A | 1-4 |
| X | WO 2014/126115 A1 (LINTEC CORP.) 21 August 2014, paragraphs [0001], [0086], [0099]-[0101], [0105]-[0107] & US 2015/0367602 A1, paragraphs [0001], [0131], [0154]-[0159], [0164]-[0172] & JP 2014-177121 A & EP 2957425 A1 & CN 105073413 A & KR 10-2015-0119341 A & TW 201500224 A | 1-4 |
| X | WO 2015/186694 A1 (LINTEC CORP.) 10 December 2015, paragraphs [0001], [0006], [0074]-[0106] & US 2017/0088684 A1, paragraphs [0001], [0009], [0129]-[0174] & EP 3153314 A1 & CN 106457763 A & KR 10-2017-0012251 A & TW 201601940 A | 1-4 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 8224825 A
- JP 2012106421 A
- JP 2013226757 A
- JP 62195024 A
- JP 2084437 A
- JP 63081122 A
- JP 1138108 A
- JP 2175726 A
- JP 5238827 A
- JP 6122852 A
- JP 6306329 A
- JP 6299118 A
- JP 9031333 A
- JP 5345826 A
- JP 4063833 A
- WO 2010107018 A
- NL 11020